# FASCICULE DE BREVET EUROPEEN

(11) **EP 2 445 138 B1**
(45) Date de publication et mention de la délivrance du brevet: **15.07.2015**
(21) Numéro de dépôt: 10188479.9
(22) Date de dépôt: 22.10.2010
(51) Int. Cl.: H04L 7/033, H03L 7/08, H03L 7/085

(54) **Unité de traitement de données, et récepteur de signaux comprenant l'unité de traitement de données**
Datenverarbeitungseinheit und Signalempfänger, der die Datenverarbeitungseinheit umfasst
Data processing unit and signal receiver including the data processing unit

(43) Date de publication de la demande: 25.04.2012
(73) Titulaire: The Swatch Group Research and Development Ltd., 2074 Marin (CH)
(72) Inventeur: Casagrande, Arnaud, 2014, Bôle (CH)
(74) Mandataire: Ravenel, Thierry Gérard Louis

(56) Documents cités:
- KR-A- 20040 006 661
- US-A1- 2007 140 392
- US-A1- 2009 147 901
- US-A1- 2010 231 195
- US-B1- 6 937 683
- US-B1- 6 965 655
- US-B2- 7 423 492

## Description

L'invention concerne une unité de traitement de données pour un récepteur de signaux porteurs d'une information. L'unité de traitement comprend un circuit de reconstruction d'horloge et/ou de données et un circuit à processeur. L'unité de traitement est prévue notamment dans le récepteur de signaux pour effectuer tout d'abord un contrôle de la cohérence d'un signal de données.

L'invention concerne également un récepteur de signaux porteurs d'une information, qui comprend une unité de traitement de données capable de juger de la cohérence des données du signal de données.

Le contrôle de la cohérence d'un signal de données par l'unité de traitement de données peut s'appliquer à tout type de récepteur, même pour une réception directe d'un signal de données sous forme brute sur un canal ou de manière filaire. Ce signal de données est généralement défini par une succession de bits dans le temps. Il faut comprendre par cohérence des données essentiellement la fiabilité des données modulées ou non, captées par le récepteur de signaux.

Habituellement un récepteur numérique de signaux radiofréquences produit un signal de données démodulées à la sortie d'un démodulateur, lorsque l'information est extraite des signaux radiofréquences captés, qui ont été transmis par un émetteur. La modulation de l'information dans les signaux radiofréquences à fréquence porteuse peut être de différents types. Il peut s'agir d'une modulation en fréquence FSK (Frequency Shift Keying en terminologie anglaise), d'une modulation en amplitude ASK (Amplitude Shift Keying en terminologie anglaise) ou d'une modulation en tout ou rien OOK (ON-OFF Keying en terminologie anglaise).

Dans un récepteur traditionnel, plusieurs étapes permettent de déterminer si l'information contenue dans les signaux radiofréquences captés est jugée convenable, c'est-à-dire que cette information est correcte et peut être utilisée par le récepteur. Si une conversion de fréquence des signaux radiofréquences captés est tout d'abord opérée par l'intermédiaire d'au moins un bloc mélangeur et au moyen de signaux oscillants d'un oscillateur local, la fréquence du signal intermédiaire en sortie du bloc mélangeur doit être dans une gamme spécifique de fréquences. La puissance des signaux radiofréquences captés doit être aussi supérieure à un niveau dit de bruit, qui caractérise le récepteur. Cette puissance peut être contrôlée par l'intermédiaire d'un indicateur de force du signal reçu (RSSI). Il peut également être opéré après démodulation de l'information et sur la base du signal de données démodulées, un calcul d'erreur lors du traitement des données du récepteur. Ce calcul d'erreur doit fournir une valeur inférieure à un seuil défini (CRC).

Par la suite, le récepteur doit encore synchroniser l'horloge des données sur la base du signal de données, avec son horloge locale. Ceci doit être fait de manière à pouvoir traiter numériquement l'information des signaux radiofréquences captés par le récepteur. Généralement avec un tel récepteur traditionnel, une acquisition complète des paquets d'information est accomplie en tenant compte des transitions correctes des données du signal de données. Un calcul d'erreur de toutes les données peut aussi être opéré comme indiqué ci-devant. S'il est constaté que l'information des signaux radiofréquences captés n'est pas correcte après tout le traitement de l'information, tout est ensuite remis à zéro pour permettre au récepteur de capter d'autres signaux radiofréquences. Ceci constitue un inconvénient car il doit donc être attendu une longue période de traitement de toute l'information avant de remettre à zéro le récepteur si l'information n'est pas correcte.

Dans la demande de brevet US 2010/0231195 A1, il est décrit un appareil et un procédé de mesure de la performance d'un circuit à boucle à verrouillage de phase PLL. Un jugement de la convergence ou non convergence de la boucle à verrouillage de phase est mesuré dans une section de mesure de la PLL. La section de mesure de la PLL fournit principalement un résultat du jugement de la convergence de la PLL, si la moyenne ou la variance calculée est jugée au-dessus ou au-dessous d'une première valeur absolue définie. Par contre, il n'est pas prévu de réduire la consommation électrique s'il n'y a pas convergence de la PLL.

La demande de brevet KR 2004 0006661 A décrit un dispositif de reconstruction d'une temporisation, qui permet de reconstruite un signal d'horloge sur la base d'une détection d'erreur de phase. Le dispositif comprend également un circuit à boucle à verrouillage de phase numérique, dans lequel l'oscillateur à commande numérique fournit en sortie un signal à impulsions en phase et un signal à impulsions en quadrature. Cependant il n'est pas prévu de contrôler la cohérence d'un signal de données pour réduire la consommation électrique si le signal de données n'est pas cohérent.

La demande de brevet US 2009/0147901 A1 décrit un dispositif de reconstruction d'horloge et des données. Ce dispositif comprend une boucle à verrouillage de phase avec un synthétiseur de fréquence. Une fréquence stable est maintenue pour des composants périphériques même si une perte de verrouillage ou une perte de signaux intervient. Cependant il n'est pas prévu de contrôler la cohérence d'un signal de données pour réduire la consommation électrique si le signal de données n'est pas cohérent.

Le brevet US 6,937,683 B1 décrit un circuit de reconstruction de temporisation ou d'horloge numérique. Un détecteur de flancs d'un signal de données est relié à une boucle à verrouillage de phase, qui est composée d'un détecteur de phase, d'un filtre de boucle et d'un oscillateur à commande numérique. La sortie de l'oscillateur à commande numérique fournit un signal à impulsions en phase, qui définit un signal reconstruit d'horloge des données. Cependant il n'est pas prévu de contrôler la cohérence d'un signal de données pour réduire la consommation électrique si le signal de données n'est pas cohérent.

La demande de brevet US 2007/0140392 A1 décrit un récepteur de signaux radiofréquences capable de gérer des signaux dans plusieurs bandes de fréquence. Il comprend un synthétiseur de fréquence, qui fournit des signaux oscillants à fréquence adaptée à un mélangeur de fréquence pour convertir en fréquence les signaux radiofréquences captés. Les signaux fournis par le mélangeur sont des signaux en bande de base, qui sont démodulés. Les signaux démodulés sont traités par la suite dans un processeur. Cependant il n'est pas prévu de contrôler la cohérence d'un signal de données pour réduire la consommation électrique si le signal de données n'est pas cohérent.

Le brevet US 6,965,655 B1 décrit un récepteur superhétérodyne de signaux radiofréquences. Ce récepteur est agencé pour augmenter la gamme dynamique de réception des signaux radiofréquences. Pour ce faire, il est prévu un contrôleur, qui adapte des paramètres de l'amplificateur LNA et du mélangeur de signaux. Cependant il n'est pas prévu de contrôler la cohérence d'un signal de données pour réduire la consommation électrique si le signal de données n'est pas cohérent.

L'invention a donc pour but de fournir une unité de traitement de données pour un récepteur de signaux porteurs d'information capable de contrôler directement et rapidement la cohérence du signal de données avant d'effectuer toutes les opérations subséquentes de traitement des données en palliant les inconvénients de l'état de la technique.

A cet effet, l'invention concerne une unité de traitement de données pour un récepteur de signaux porteurs d'une information, qui comprend les caractéristiques mentionnées dans la revendication indépendante 1.

Des formes d'exécution particulières de l'unité de traitement de données sont définies dans les revendications dépendantes 2 à 11

Un avantage d'une telle unité de traitement des données selon l'invention, réside dans le fait qu'elle permet de rapidement savoir si les données du signal de données reçu en entrée du circuit de reconstruction d'horloge et de données sont correctes, et non du bruit ou une mauvaise information. Pour ce faire, dans la boucle à verrouillage de phase numérique du circuit de reconstruction d'horloge et de données, il est calculé par le circuit processeur, la moyenne et la variance du signal d'entrée de l'oscillateur à commande numérique NCO. Ce calcul est opéré à chaque impulsion d'un signal à impulsions de l'oscillateur à commande numérique suite à une transition binaire dans le signal de données. Si aussi bien la moyenne dans le temps, que la variance de ce signal d'entrée est proche de 0, cela signifie directement que le signal de données est cohérent. Dans ces conditions, toutes les opérations subséquentes dans l'unité de traitement peuvent être effectuées. Dans le cas contraire, une remise à zéro immédiate ou un déclenchement du récepteur peuvent être commandés par l'intermédiaire de l'unité de traitement des données.

A cet effet, l'invention concerne également un récepteur de signaux porteurs d'une information, qui comprend les caractéristiques mentionnées dans la revendication indépendante 12.

Les buts, avantages et caractéristiques d'une unité de traitement de données pour un récepteur de signaux porteurs d'une information apparaîtront mieux dans la description suivante sur la base d'au moins une forme d'exécution non limitative illustrée par les dessins sur lesquels :
la figure 1 représente de manière simplifiée une forme d'exécution d'un récepteur de signaux porteurs d'une information, tel qu'un récepteur de signaux à modulation FSK, qui comprend une unité de traitement de données selon l'invention,
la figure 2 représente les différents blocs électroniques du circuit de reconstruction d'horloge et de données de l'unité de traitement de données selon l'invention, et
la figure 3 représente un graphique temporel de différents signaux du circuit de reconstruction d'horloge et de données de l'unité de traitement de données selon l'invention.

Dans la description suivante, tous les composants du récepteur de signaux porteurs d'une information, qui sont bien connus d'un homme du métier dans ce domaine technique, ne sont décrits que de manière simplifiée. Le récepteur peut par exemple être un récepteur de signaux à modulation de fréquence (FSK), mais tout autre type de récepteur peut être envisagé dans lequel une unité de traitement de données selon l'invention peut être utilisée.

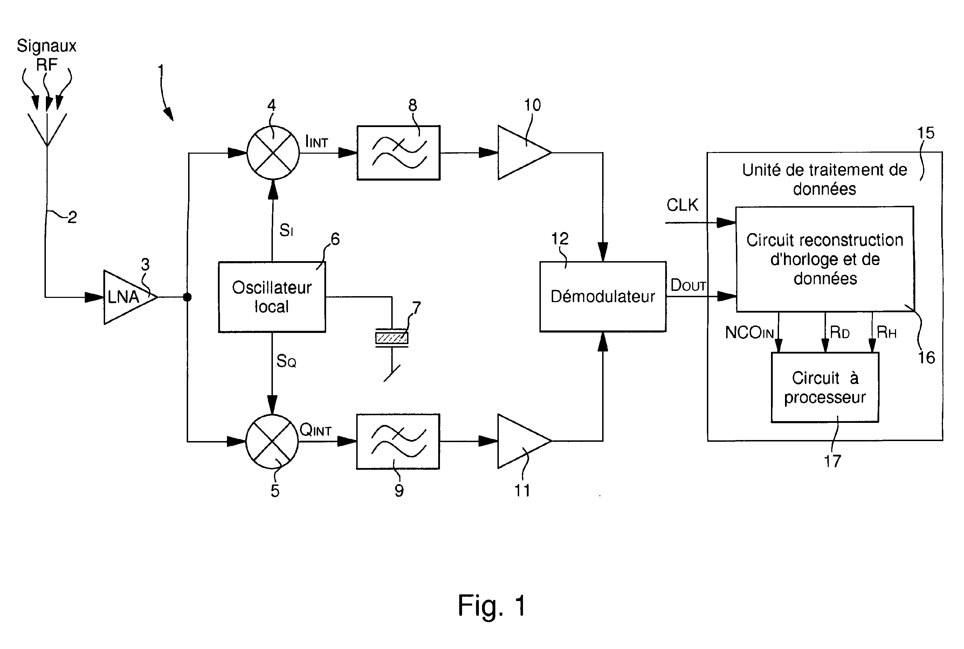

La figure 1 représente un récepteur de signaux porteurs d'information 1. Ce récepteur de signaux est par exemple un récepteur de signaux radiofréquences RF, qui comprend une unité de traitement de données 15 selon l'invention, qui est capable de calculer la cohérence d'un signal de données D_{OUT}.

Le récepteur de signaux radiofréquences 1 peut être un récepteur de signaux radiofréquences à modulation FSK traditionnel, dans lequel il peut être effectué une conversion en fréquence des signaux radiofréquences captés par une antenne 2 dans deux branches distinctes en quadrature. Chaque branche comprend un mélangeur 4, 5 pour effectuer la conversion de fréquence avec des signaux oscillants fournis par un oscillateur local 6. L'oscillateur local 6 peut comprendre un synthétiseur de fréquence qui fournit un signal oscillant en phase S_{I} et un signal oscillant en quadrature S_{Q}. Ce synthétiseur de fréquence est généralement relié à un oscillateur à quartz 7, qui fournit un signal à fréquence de référence déterminée pour la boucle à verrouillage de phase et fréquence du synthétiseur.

Dans une première branche, un premier mélangeur 4 par exemple à haute fréquence, permet de mélanger les signaux radiofréquences RF, captés par l'antenne 2 et amplifiés par un amplificateur LNA 3, avec le signal oscillant en phase S_{I} pour fournir un signal intermédiaire en phase I_{INT}. Dans une seconde branche, un second mélangeur 5, par exemple à haute fréquence, permet de mélanger les signaux RF filtrés et amplifiés avec le signal oscillant en quadrature S_{Q} pour fournir un signal intermédiaire en quadrature Q_{INT}. Les signaux intermédiaires I_{INT} et Q_{INT} peuvent être par exemple des signaux en bande de base suite à une conversion directe en fréquence. Ces signaux intermédiaires sont ensuite filtrés chacun dans un filtre passe-bas respectif 8 et 9 pour fournir des signaux filtrés. Les signaux filtrés passent encore chacun par un limiteur amplificateur respectif 10 et 11 avant une démodulation des données dans un démodulateur 12 traditionnel.

Le démodulateur 12 fournit sur la base du signal intermédiaire en phase filtré et amplifié et du signal intermédiaire en quadrature filtré et amplifié, un signal de données D_{OUT}, qui est un signal binaire ou flux de données. Les deux signaux intermédiaires en phase I_{INT} et en quadrature Q_{INT} sont nécessaires pour la démodulation des données. Ils permettent par exemple de discriminer le signe de la déviation de fréquence dans le cas d'une modulation en fréquence des données dans les signaux radiofréquences RF captés.

Le démodulateur 12 peut être une simple bascule du type D, qui reçoit en entrée D, par exemple le signal intermédiaire en phase I_{INT} et est cadencée à sa borne de cadencement, par le signal intermédiaire en quadrature Q_{INT}. Avec cette bascule et en fonction de l'état de chaque bit de données, la sortie de la bascule est à un niveau 1 ou à un niveau 0 dans le signal binaire de données D_{OUT}.

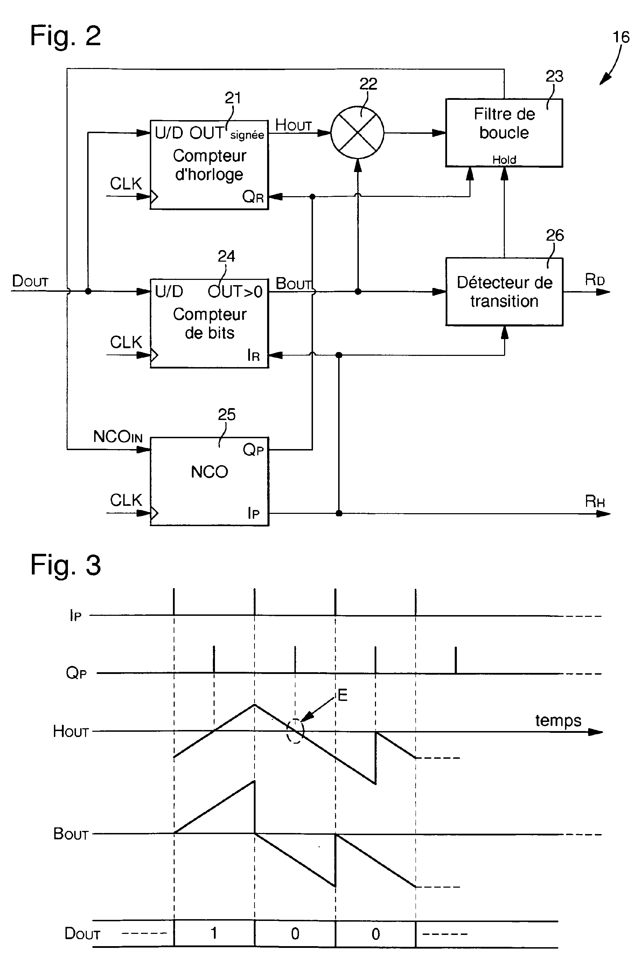

Le récepteur de signaux radiofréquences RF comprend également une unité de traitement des données 15, qui reçoit le signal binaire de données D_{OUT} du démodulateur 12. Ce signal binaire de données est fourni à un circuit de reconstruction d'horloge et de données 16, qui est cadencé par un signal d'horloge local CLK. Le circuit de reconstruction d'horloge et de données comprend principalement une boucle à verrouillage de phase numérique, dans laquelle est disposée un oscillateur à commande numérique NCO comme expliqué plus en détail ci-dessous en référence aux figures 2 et 3. L'unité de traitement des données 15 comprend également au moins un circuit à processeur 17, qui est relié au circuit de reconstruction d'horloge et de données 16. Le circuit à processeur est prévu pour pouvoir calculer dans le temps la moyenne et la variance d'un signal numérique d'entrée ou mot binaire d'entrée NCO_{IN} de l'oscillateur à commande numérique. La moyenne et la variance dans le temps peuvent être calculées facilement par exemple au moyen des algorithmes de moyenne glissante et de max-min glissants, qui sont bien connus. Ces calculs permettent donc d'extraire une indication de la cohérence de l'information des signaux radiofréquences captés. Si la moyenne et la variance dans le temps, qui sont calculées par le circuit à processeur 17, sont en dessus d'un seuil défini préalablement, l'information des signaux radiofréquences captés est jugée mauvaise, et une remise à zéro du récepteur peut être immédiatement effectuée. Il en est de même si le signal de données ne concerne que du bruit.

Le circuit à processeur 17 peut également recevoir du circuit de reconstruction d'horloge et de données, un signal reconstruit d'horloge R_{H} et un signal reconstruit du flux des données R_{D}. Un traitement de l'information de l'unité de traitement peut ainsi être effectué par l'intermédiaire du circuit à processeur sur la base de ces signaux reconstruits, si l'information des signaux captés par le récepteur est jugée correcte. L'unité de traitement peut aussi faire partie d'un système d'acquisition de données, qui comprend une mémoire pour agir rapidement dans le système. Les signaux reconstruits d'horloge et de données peuvent être stockés dans la mémoire.

Le signal d'horloge local CLK, qui cadence le circuit de reconstruction d'horloge et de données 16, ainsi que le circuit à processeur 17, peut être obtenu sur la base du signal à fréquence de référence de l'oscillateur à quartz 7 de l'oscillateur local 6. Un certain nombre de diviseurs non représentés peut permettre de diviser la fréquence du signal à fréquence de référence pour fournir le signal d'horloge local CLK.

Uniquement à titre d'exemple non limitatif, la fréquence du signal de référence peut être de l'ordre de 26 MHz, alors qu'il peut être choisi d'avoir une fréquence du signal d'horloge local CLK à 1 MHz. Ce signal d'horloge local CLK doit par contre être établi avec une fréquence, qui doit être au moins 10 fois supérieure à la fréquence du débit des données du signal de données, et de préférence 100 fois supérieure. Par exemple dans le cas d'un débit de données à 10 kbits/s, il peut être prévu un signal d'horloge local CLK à une fréquence de l'ordre de 1 MHz. Cela permet d'effectuer un sur-échantillonnage du signal binaire de données D_{OUT}, qui peut être défini également comme un flux de données, comme expliqué ci-après en référence aux figures 2 et 3.

La figure 2 représente les différents composants du circuit de reconstruction d'horloge et de données 16 de l'unité de traitement des données. Grâce à ce circuit, il est possible de récupérer ou reconstruire les données et l'horloge du signal de données suite aux signaux porteurs d'une information captés par le récepteur. Pour ce faire, l'opération de récupération des données et de l'horloge du signal de données, consiste à supprimer d'éventuelles impulsions transitoires des signaux captés et à reconstruire le flux de bits transmis. Suite à un codage spécifique, le signal de données D_{OUT} est composé d'une succession de bits, dans laquelle il peut être prévu au maximum 4 bits successifs de même valeur avant une transition à un bit d'une valeur différente. Ceci permet un bon fonctionnement du circuit de reconstruction d'horloge et de données 16 de l'unité de traitement des données.

Le circuit de reconstruction d'horloge et de données 16 comprend une boucle à verrouillage de phase numérique. Le signal de données D_{OUT}, c'est-à-dire le flux des données, est sur-échantillonné à l'aide d'un signal d'horloge local CLK. Ce signal d'horloge local CLK est dérivé de l'oscillateur à quartz de l'oscillateur local comme précédemment mentionné. Le circuit comprend dans la boucle à verrouillage de phase numérique, un oscillateur à commande numérique NCO 25, qui produit en sortie deux signaux à impulsions en quadrature I_{P} et Q_{P}, et deux compteurs 21 et 24. L'oscillateur NCO 25 et les deux compteurs 21 et 24 sont cadencés par le signal d'horloge local CLK. Les deux compteurs sont capables de compter ou décompter en fonction du niveau du signal de données à l'entrée du circuit. Les deux compteurs sont signés et capables d'être remis à zéro. Ils comportent également un blocage en fin de course de manière à empêcher un "renversement".

Dans le cas où le signal de données D_{OUT} est à un niveau haut pour définir un état "1" d'un bit de données, les deux compteurs 21 et 24 sont prévus pour effectuer un comptage pendant une durée correspondant au moins à la durée du bit de données. Par contre, quand le signal de données D_{OUT} est à un niveau bas pour définir un état "0" d'un bit de données, les deux compteurs 21 et 24 sont prévus pour effectuer un décomptage pendant au moins la durée du bit de données. Le premier compteur 21 est un compteur d'horloge, alors que le second compteur 24 est un compteur de bits de données.

Le premier compteur 21 est un compteur d'horloge, qui intègre le flux de données de part et d'autre de la transition d'un bit. La transition d'un bit concerne le passage d'un état "0" à l'état "1" du signal de données ou le passage d'un état "1" à l'état "0" du signal de données. Il n'y a pas de transition binaire dans le signal de données D_{OUT} lors du passage d'un bit à un autre bit successif si les bits successifs sont dans un même état "0" ou "1 ". Le signal à impulsions en quadrature Q_{P}, qui est généré par l'oscillateur à commande numérique 25, est fourni à l'entrée de remise à zéro Q_{R} du premier compteur. Si la fréquence et la phase des impulsions Q_{P} sont exactement alignées sur celles du signal de données D_{OUT} à l'entrée du circuit 16, la sortie H_{OUT} est toujours nulle à l'instant de chaque remise à zéro suite à une transition binaire dans le signal de données. Par contre tout décalage, lors de la reconstruction du signal reconstruit d'horloge R_{H} fourni à la sortie I_{P} de l'oscillateur à commande numérique 25, entraîne une erreur positive ou négative en sortie du compteur d'horloge 21 au moment de la remise à zéro à l'entrée Q_{R} du compteur 21.

A l'instant de chaque impulsion du signal à impulsions en quadrature Q_{P}, la polarité de l'erreur E, montrée en partie à la figure 3, est directement relative à la valeur du bit du signal de données à traiter. Il est donc prévu de multiplier cette erreur dans un multiplicateur 22 par le signal de sortie B_{OUT} du second compteur de bits 24, qui tient compte de la valeur du bit du signal de données à traiter. Ceci permet de produire une erreur indépendante de la valeur du bit de données. Si la fréquence de génération des signaux à impulsions I_{P} et Q_{P} à la sortie de l'oscillateur à commande numérique 25, est plus faible que la fréquence d'horloge du signal de données, l'erreur est positive à la sortie H_{OUT}, s'il s'agit d'un bit de données à l'état "1", et négative s'il s'agit d'un bit de données à l'état "0". Cette erreur en sortie H_{OUT} doit donc être multipliée par une valeur "+1" en sortie B_{OUT} du second compteur 24 si l'erreur est positive avec le bit de données à l'état "1 ", et par une valeur "-1" en sortie B_{OUT} si l'erreur est négative avec le bit de données à l'état "0".

Il en est de même si la fréquence de génération des signaux à impulsions I_{P} et Q_{P} à la sortie de l'oscillateur à commande numérique est plus grande que la fréquence d'horloge du signal de données. Mais dans ce cas et inversement à la précédente erreur susmentionnée, l'erreur en sortie H_{OUT} doit être multipliée par une valeur "-1" en sortie B_{OUT} du second compteur 24 si l'erreur est positive avec le bit de données à l'état "0", et par une valeur "+1" en sortie B_{OUT} si l'erreur est négative avec le bit de données à l'état "1".

Le signal en sortie du multiplicateur 22 est filtré dans un filtre de boucle numérique 23. Dans le filtre de boucle, il peut être prévu un élément à bascule du type D, qui est cadencé par le signal à impulsions en quadrature Q_{P} de l'oscillateur à commande numérique 25. Cet élément à bascule permet au filtre de boucle de fournir un signal numérique d'entrée ou mot binaire NCO_{IN} à l'oscillateur à commande numérique 25. Ce signal numérique d'entrée est fourni à chaque impulsion du signal à impulsions en quadrature Q_{P}, qui fait suite à une transition binaire dans le signal de données. Dans le cas où aucune transition binaire n'est opérée dans deux bits successifs du signal de données, uniquement la précédente valeur du signal d'entrée numérique est fournie à l'oscillateur à commande numérique 25. Le signal numérique d'entrée ou mot binaire NCO_{IN} fourni par le filtre de boucle, représente la valeur de sortie H_{OUT}, c'est-à-dire l'erreur E pondérée ou atténuée par le filtre de boucle 23 au moment de la remise à zéro du compteur 21. Suite à la transition binaire, ce signal d'entrée NCO_{IN} permet de corriger la fréquence et la phase suite à l'information de la sortie du premier compteur d'horloge 21 à l'instant de l'impulsion en quadrature Q_{P}.

A travers le filtre de boucle 23, il est opéré une atténuation du signal par exemple d'un facteur 0.25. Bien entendu si l'information des signaux radiofréquences captés est correcte, l'erreur E devient nulle au moment de chaque impulsion du signal à impulsions en quadrature Q_{P} à la suite de chaque transition binaire dans le signal de données. Par les calculs de la moyenne et de la variance dans le circuit à processeur du signal numérique d'entrée NCO_{IN}, il peut ainsi être directement constaté qu'aussi bien la moyenne dans le temps, que la variance de ce signal est proche de 0. Cela signifie donc que le signal de données est cohérent. Pour ce contrôle de cohérence du signal de données, il peut suffire donc de quelques transitions binaires dans le signal de données pour déterminer la cohérence du signal de données. A la différence d'un signal de données cohérent, la variance du bruit n'est jamais nulle et se trouve en dessus d'un seuil de cohérence prédéfini. Ceci permet donc de bien différencier une information correcte des signaux radiofréquences captés par rapport à une mauvaise information ou simplement du bruit.

Il est à noter que le signal de sortie H_{OUT} du premier compteur 21 et le signal numérique d'entrée NCO_{IN} de l'oscillateur à commande numérique 25 sont des mots binaires à n bits, par exemple au moins 5 bits, non représentés. De ce fait, l'élément à bascule D dans le filtre de boucle peut comprendre une bascule du type D pour chaque bit du mot binaire, par exemple 5 bascules cadencées chacune par le signal à impulsions en quadrature Q_{P}. Par contre, le signal de sortie du second compteur 24 est à 1 bit. Le mot binaire NCO_{IN} peut ainsi varier entre -2ⁿ et 2ⁿ.

Pour la mise en fonction de la boucle à verrouillage de phase numérique du circuit de reconstruction d'horloge et de données 16, il doit en principe être détecté une transition dans le signal de données D_{OUT}. Pour ce faire, le second compteur 24 fournit également le signal de sortie B_{OUT} à un détecteur de transition 26, qui reçoit également le signal à impulsions en phase Ip de l'oscillateur à commande numérique 25. Ce détecteur de transition peut être constitué par un registre à décalage. Ce signal à impulsions en phase I_{P}, qui définit le signal reconstruit d'horloge R_{H}, est également fourni à l'entrée de remise à zéro I_{R} du second compteur 24. Ce détecteur de transition 26 fournit à une sortie le signal reconstruit du flux des données R_{D}. Une autre sortie du détecteur de transition 26 commande un maintien de la précédente valeur dans le filtre de boucle 23 s'il n'y a pas de changement de valeur du bit successif du signal de données comme indiqué ci-devant.

La stabilité et le temps de mise en fonction du circuit de reconstruction d'horloge et de données dépendent du gain de la boucle à verrouillage de phase numérique, ainsi que du facteur de sur-échantillonnage. Ce facteur de sur-échantillonnage est relatif à la fréquence du signal d'horloge local CLK. S'il est opéré un sur-échantillonnage de 45, un gain de 0.25 correspond au plus faible temps de mise en fonction avec une stabilité acceptable. Ce gain de 0.25 peut facilement être implémenté par un décalage de deux bits.

Comme le circuit 16 est entièrement numérique, la fréquence du signal d'horloge local CLK est une variable indépendante et le circuit fonctionne de manière parfaitement identique pour tous les couples f(flux de données)/f(CLK) constants. La fréquence du signal d'horloge local CLK peut être donc fixée à 45-f(flux de données). Le choix du facteur de sur-échantillonnage, par exemple égal à 45, est en relation directe avec la taille typique des impulsions transitoires, que l'on peut observer à la sortie du démodulateur et définit en fait la gigue de l'horloge reconstruite. Cette valeur est aussi directement liée à la fréquence du débit de données, qui peut être paramétrable et à la fréquence de l'oscillateur à quartz, qui peut valoir 13 ou 26 MHz par exemple.

Les calculs de la moyenne (glissante) et de la variance (glissante) du signal numérique d'entrée NCO_{IN} correspondent à un calcul équivalent de l'amplitude RMS (Root Mean Square en terminologie anglaise) de ces valeurs. Si l'horloge de données du signal de données D_{OUT}, est correctement alignée sur l'horloge locale, la valeur RMS en entrée de l'oscillateur à commande numérique 25 est proche de zéro. Plus l'information reçue est douteuse, par exemple dans le cas d'une source de bruit, plus la valeur RMS associée en entrée de l'oscillateur à commande numérique 25 augmente et plus il faut corriger ce dernier.

La figure 3 représente de manière simplifiée différents signaux dans le temps du circuit de reconstruction d'horloge et de données de l'unité de traitement de données selon l'invention. Il est représenté notamment les deux signaux à impulsions en phase I_{P} et en quadrature Q_{P} de l'oscillateur à commande numérique, le signal de sortie du premier compteur d'horloge H_{OUT}, le signal de sortie du second compteur de bits B_{OUT}, et le signal de données D_{OUT}.

Dans le cas présenté, le signal de sortie H_{OUT} est bien proche de 0 suite à une impulsion Q_{P} fournie par l'oscillateur à commande numérique pour la remise à zéro du compteur, à la suite d'une transition binaire de "1" à "0" dans le signal de données. Cela signifie que le signal reconstruit d'horloge est bien ajusté à l'horloge des données, et qu'il est bien fourni un signal reconstruit de données d'une information correcte captée par le récepteur. Le signal de données peut donc être considéré comme cohérent. Si une erreur positive ou négative E survient, c'est-à-dire qu'à l'instant de la remise à zéro, la sortie du premier compteur n'est pas à 0, une correction est effectuée par l'intermédiaire de l'oscillateur à commande numérique. La fréquence et la phase des signaux à impulsions I_{P} et Q_{P} sont ainsi adaptées. Lors d'un bit à l'état "1 ", le second compteur opère bien un comptage par incrément d'une unité à chaque coup du signal d'horloge local CLK. Par contre lors d'un bit à l'état "0", le second compteur opère bien un décomptage par décrément d'une unité à chaque coup du signal d'horloge interne CLK. Il en est de même pour le premier compteur, mais l'opération de remise à zéro par les impulsions en quadrature Q_{P} intervient entre deux impulsions du signal à impulsions en phase I_{P}. Les signaux de sortie H_{OUT} et B_{OUT}, représentés sous forme triangulaire, sont en réalité sous forme d'escaliers pour l'opération d'incrémentation ou de décrémentation à chaque coup d'horloge CLK.

A partir de la description qui vient d'être faite, plusieurs variantes de l'unité de traitement des données pour un récepteur de signaux porteurs d'une information peuvent être conçues par l'homme du métier sans sortir du cadre de l'invention définie par les revendications. Le signal de données pour l'unité de traitement de données peut être fourni directement d'un émetteur sur un canal de transmission ou sous forme filaire sans l'utilisation d'un démodulateur. Dans le cas d'un récepteur de signaux radiofréquences, il peut être opéré une double conversion de fréquence avant de fournir le signal de données à l'unité de traitement des données. Le récepteur peut aussi démoduler des signaux radiofréquences à modulation d'amplitude ou en tout ou rien pour fournir un signal de données à contrôler par l'unité de traitement des données.

## Revendications

1. Unité de traitement de données (15) pour un récepteur (1) de signaux porteurs d'information, ladite unité comprenant :
- un circuit de reconstruction d'horloge et de données (16), qui est cadencé par un signal d'horloge local (CLK) et qui comprend une boucle à verrouillage de phase numérique, dans laquelle est disposé un oscillateur à commande numérique (25), pour générer en sortie au moins un signal à impulsions (I_{P}, Q_{P}) dont la phase et la fréquence peuvent être adaptées sur la base d'un signal de données (D_{OUT}) reçu en entrée du circuit de reconstruction d'horloge et de données (16), et
- un circuit à processeur (17) relié au circuit de reconstruction d'horloge et de données (16),
**caractérisée en ce que** le circuit à processeur (17) est agencé pour pouvoir calculer dans le temps la moyenne et la variance du signal d'entrée numérique (NCO_{IN}) de l'oscillateur à commande numérique (25) de manière à déterminer la cohérence du signal de données (D_{OUT}) si la moyenne et la variance calculées sont en dessous d'un seuil de cohérence prédéfini, et être en mesure d'effectuer une remise à zéro complète du récepteur (I) si la moyenne ou la variance calculées du signal d'entrée numérique (NCO_{IN}) de l'oscillateur à commande numérique sont en dessus du seuil de cohérence prédéfini.

2. Unité de traitement de données (15) selon la revendication 1, **caractérisée en ce que** l'oscillateur à commande numérique (25) est agencé pour fournir en sortie un signal à impulsions en phase (I_{P}) et un signal à impulsions en quadrature (Q_{P}).

3. Unité de traitement de données (15) selon la revendication 2, **caractérisée en ce que** la boucle à verrouillage de phase numérique comprend un premier compteur d'horloge (21), pour recevoir en entrée le signal de données (D_{OUT}) et pour être cadencé par le signal d'horloge local (CLK) pour sur-échantillonner le signal de données (D_{OUT}), le premier compteur (21) étant agencé pour être remis à zéro à une entrée de remise à zéro (Q_{R}) à chaque impulsion du signal à impulsions en quadrature (Q_{P}) fourni par l'oscillateur à commande numérique (25), une valeur du signal de sortie (H_{OUT}) du premier compteur (21) au moment de la remise à zéro suite à une transition binaire du signal de données (D_{OUT}) permettant d'adapter l'oscillateur à commande numérique (25).

4. Unité de traitement de données (15) selon la revendication 2, caractérisée ce que le signal à impulsions en phase (I_{P}) fourni par l'oscillateur à commande numérique (25) définit un signal reconstruit d'horloge des données (R_{H}).

5. Unité de traitement de données (15) selon la revendication 3, caractérisée ce que la boucle à verrouillage de phase numérique comprend un filtre de boucle numérique (23) pour filtrer le signal de sortie (H_{OUT}) du premier compteur d'horloge (21) afin de fournir un signal d'entrée numérique (NCO_{IN}) à l'oscillateur à commande numérique (25) lors d'une impulsion du signal à impulsions en quadrature (Q_{P}) à la suite d'une transition binaire dans le signal de données (D_{OUT}).

6. Unité de traitement de données (15) selon la revendication 5, caractérisée ce que le filtre de boucle (23) est agencé pour opérer une atténuation d'un facteur K, tel qu'un facteur égal à 0.25, du signal de sortie du premier compteur (21) pour fournir le signal d'entrée numérique (NCO_{IN}).

7. Unité de traitement de données (15) selon l'une des revendications 3,5 out, **caractérisée en ce que** le circuit de reconstruction d'horloge et de données (16) comprend un second compteur de bits (24), pour recevoir en entrée le signal de données (D_{OUT}) et pour être cadencé par le signal d'horloge local (CLK) pour sur-échantillonner le signal de données (D_{OUT}), et **en ce que** le second compteur de données (24) est agencé pour être remis à zéro à une entrée de remise à zéro (I_{R}) à chaque impulsion du signal à impulsions en phase (I_{P}) fourni par l'oscillateur à commande numérique (25).

8. Unité de traitement de données (15) selon la revendication 7, **caractérisée en ce que** circuit de reconstruction d'horloge et de données (16) comprend un détecteur de transition (26), pour recevoir le signal de sortie (B_{OUT}) du second compteur de bits (24) afin de fournir en sortie un signal reconstruit de données (R_{H}).

9. Unité de traitement de données (15) selon la revendication 7, **caractérisée en ce que** la boucle à verrouillage de phase numérique comprend un multiplicateur (22) pour multiplier le signal de sortie (H_{OUT}) du premier compteur d'horloge (21) par le signal de sortie (B_{OUT}) du second compteur de bits (24), qui est agencé pour prendre une valeur "+1" pour un bit à l'état "1" du signal de données et une valeur "-1" pour un bit à l'état "0" du signal de données, afin de fournir au filtre de boucle (23) un signal de sortie (H_{OUT}) du premier compteur d'horloge (21) de polarité adaptée au bit en cours du signal de données (D_{OUT}).

10. Unité de traitement de données (15) selon la revendication 8, **caractérisée en ce que** le détecteur de transition (26) est cadencé par le signal à impulsions en phase (I_{P}) de l'oscillateur à commande numérique (25), et **en ce que** le détecteur de transition fournit un signal de commande au filtre de boucle (23) pour le maintien du précédent signal d'entrée numérique (NCO_{IN}) à fournir à l'oscillateur à commande numérique si le détecteur de transition (26) ne détecte pas de transition binaire d'un bit à l'autre du signal de données (D_{OUT}).

11. Unité de traitement de données (15) selon la revendication 1, **caractérisée en ce que** le circuit à processeur (17) comprend des moyens de mémorisation dans lesquels sont enregistrés un algorithme de moyenne glissante et/ou un algorithme de max-min glissants de manière à calculer la moyenne et la variance dans le temps du signal d'entrée numérique (NCO_{IN}) de l'oscillateur à commande numérique (25), afin de déterminer la cohérence du signal de données (D_{OUT}).

12. Récepteur (1) de signaux porteurs d'information, ledit récepteur comprenant :
- une antenne (2) de réception de signaux porteurs d'information,
- au moins un amplificateur à faible bruit (3) pour amplifier et filtrer les signaux captés par l'antenne,
- un oscillateur local (6) pour fournir des signaux oscillants haute fréquence (S_{I}, S_{Q}),
- au moins un bloc mélangeur (4, 5) pour mélanger les signaux captés filtrés et amplifiés avec les signaux oscillants haute fréquence fournis par l'oscillateur local afin de produire des signaux intermédiaires (I_{INT}, Q_{INT}), dont la fréquence est égale à la différence entre la fréquence des signaux oscillants haute fréquence et une fréquence porteuse des signaux captés,
- au moins un filtre passe-bas (8, 9) pour filtrer les signaux intermédiaires,
- une unité de traitement de données (15) selon l'une des revendications précédentes, et
- un démodulateur (12) recevant les signaux intermédiaires filtrés afin de fournir un signal de données (D_{OUT}) à l'unité de traitement des données (15).

13. Récepteur (1) selon la revendication 12, **caractérisé en ce qu'**il est un récepteur de signaux radiofréquences à modulation des données du type FSK.

14. Récepteur (1) selon la revendication 12, **caractérisé en ce que** le signal d'horloge local (CLK) provient d'un signal de référence de l'oscillateur local (6), dont la fréquence est divisée par une série de diviseurs, **en ce que** la fréquence du signal d'horloge local est agencée pour être entre 10 à 100 fois supérieure à la fréquence du débit des données du signal de données, de préférence égale à 45 fois la fréquence du débit des données.

## Patentansprüche

1. Datenverarbeitungseinheit (15) für einen Empfänger (1) von Informationsträgersignalen, wobei die Einheit umfasst:
- eine Takt- und Daten-Wiedergewinnungsschaltung (16), die durch ein lokales Taktsignal (CLK) getaktet wird und eine digitale Phasenverriegelungsschleife enthält, in der ein Oszillator (25) mit digitaler Steuerung angeordnet ist, um am Ausgang wenigstens ein Signal aus Impulsen (I_{P}, Q_{P}) zu erzeugen, deren Phase und deren Frequenz anhand eines Datensignals (D_{OUT}), das am Eingang der Takt- und Daten-Wiedergewinnungsschaltung (16) empfangen wird, angepasst werden können, und
- eine Prozessorschaltung (17), die mit der Takt- und Datenwiedergewinnungsschaltung (16) verbunden ist,
**dadurch gekennzeichnet, dass** die Prozessorschaltung (17) dafür ausgelegt ist, den zeitlichen Mittelwert und die Varianz des digitalen Eingangssignals (NCO_{IN}) des Oszillators (25) mit digitaler Steuerung berechnen zu können, derart, dass die Kohärenz des Datensignals (D_{OUT}) bestimmt wird, falls der berechnete Mittelwert und die berechnete Varianz unterhalb eines im Voraus definierten Kohärenzschwellenwerts liegen und in der Lage ist, eine vollständige Nullrücksetzung des Empfängers (1) auszuführen, falls der berechnete Mittelwert und die berechnete Varianz des digitalen Eingangssignals (NCO_{IN}) des Oszillators mit digitaler Steuerung oberhalb des im Voraus definierten Kohärenzschwellenwerts liegen.

2. Datenverarbeitungseinheit (15) nach Anspruch 1, **dadurch gekennzeichnet, dass** der Oszillator (25) mit digitaler Steuerung dafür ausgelegt ist, am Ausgang ein Signal (I_{P}) mit Inphase-Impulsen und ein Signal (Q_{P}) mit Quadratur-Impulsen zu liefern.

3. Datenverarbeitungseinheit (15) nach Anspruch 2, **dadurch gekennzeichnet, dass** die digitale Phasenverriegelungsschleife einen ersten Taktzähler (21) umfasst, um am Eingang das Datensignal (D_{OUT}) zu empfangen und um durch das lokale Taktsignal (CLK) getaktet zu werden, um das Datensignal (D_{OUT}) überabzutasten, wobei der erste Zähler (21) dafür ausgelegt ist, an einem Nullrücksetzeingang (Q_{R}) bei jedem Impuls des Signals (Q_{P}) mit Quadratur-Impulsen, das von dem Oszillator (25) mit digitaler Steuerung geliefert wird, auf null zurückgesetzt zu werden, wobei ein Wert des Ausgangssignals (H_{OUT}) des ersten Zählers (21) zum Zeitpunkt der Nullrücksetzung nach einem binären Übergang des Datensignals (D_{OUT}) ermöglicht, den Oszillator (25) mit digitaler Steuerung anzupassen.

4. Datenverarbeitungseinheit (15) nach Anspruch 2, **dadurch gekennzeichnet, dass** das Signal (I_{P}) mit Inphase-Impulsen, das von dem Oszillator (25) mit digitaler Steuerung geliefert wird, ein wiedergewonnenes Takt- und Datensignal (R_{H}) definiert.

5. Datenverarbeitungseinheit (15) nach Anspruch 3, **dadurch gekennzeichnet, dass** die digitale Phasenverriegelungsschleife ein digitales Schleifenfilter (23) umfasst, um das Ausgangssignal (H_{OUT}) des ersten Taktzählers (21) zu filtern, um an den Oszillator (25) mit digitaler Steuerung bei einem Impuls des Signals (Q_{P}) mit Quadratur-Impulsen nach einem binären Übergang in dem Datensignal (D_{OUT}) ein digitales Eingangssignal (NCO_{IN}) zu liefern.

6. Datenverarbeitungseinheit (15) nach Anspruch 5, **dadurch gekennzeichnet, dass** das Schleifenfilter (23) dafür ausgelegt ist, eine Dämpfung mit Faktor K, etwa einem Faktor von 0,25, des Ausgangssignals des ersten Zählers (21) zu bewirken, um das digitale Eingangssignal (NCO_{IN}) zu liefern.

7. Datenverarbeitungseinheit (15) nach einem der Ansprüche 3, 5 oder 6, **dadurch gekennzeichnet, dass** die Takt- und Datenwiedergewinnungsschaltung (16) einen zweiten Bitzähler (24) umfasst, um am Eingang das Datensignal (D_{OUT}) zu empfangen und um durch das lokale Taktsignal (CLK) getaktet zu werden, um das Datensignal (D_{OUT}) überabzutasten, und dass der zweite Datenzähler (24) dafür ausgelegt ist, an einem Nullrücksetzeingang (I_{R}) bei jedem Impuls des Signals (I_{P}) mit Inphase-Impulsen, das von dem Oszillator (25) mit digitaler Steuerung geliefert wird, auf null zurückgesetzt zu werden.

8. Datenverarbeitungseinheit (15) nach Anspruch 7, **dadurch gekennzeichnet, dass** die Takt- und Datenwiedergewinnungsschaltung (16) einen Übergangsdetektor (26) umfasst, um das Ausgangssignal (B_{OUT}) des zweiten Bitzählers (24) zu empfangen, um am Ausgang ein wiedergewonnenes Datensignal (R_{H}) zu liefern.

9. Datenverarbeitungseinheit (15) nach Anspruch 7, **dadurch gekennzeichnet, dass** die digitale Phasenverriegelungsschleife einen Multiplizierer (22) umfasst, um das Ausgangssignal (H_{OUT}) des ersten Taktzählers (21) mit dem Ausgangssignal (B_{OUT}) des zweiten Bitzählers (24), der dafür ausgelegt ist, einen Wert "+1" für ein Bit im Zustand "1" des Datensignals anzunehmen und einen Wert "-1" für ein Bit im Zustand "0" des Datensignals anzunehmen, zu multiplizieren, um an das Schleifenfilter (23) ein Ausgangssignal (H_{OUT}) des ersten Taktzählers (21) mit einer Polarität, die an das aktuelle Bit des Datensignals (D_{OUT}) angepasst ist, zu liefern.

10. Datenverarbeitungseinheit (15) nach Anspruch 8, **dadurch gekennzeichnet, dass** der Übergangsdetektor (26) durch das Signal (I_{P}) mit Inphase-Impulsen des Oszillators (25) mit digitaler Steuerung getaktet wird und dass der Übergangsdetektor an das Schleifenfilter (23) ein Steuersignal liefert, um das vorhergehende digitale Eingangssignal (NCO_{IN}), das an den Oszillator mit digitaler Steuerung geliefert werden soll, aufrecht zu erhalten, falls der Übergangsdetektor (26) keinen binären Übergang eines Bits zum anderen des Datensignals (D_{OUT}) detektiert.

11. Datenverarbeitungseinheit (15) nach Anspruch 1, **dadurch gekennzeichnet, dass** die Prozessorschaltung (17) Speichermittel umfasst, in denen ein Algorithmus für gleitenden Mittelwert und/oder ein Algorithmus für gleitende Maxima/Minima aufgezeichnet sind, derart, dass der zeitliche Mittelwert und die Varianz des digitalen Eingangssignals (NCO_{IN}) des Oszillators (25) mit digitaler Steuerung berechnet werden, um die Kohärenz des Datensignals (D_{OUT}) zu bestimmen.

12. Empfänger (1) von Informationsträgersignalen, wobei der Empfänger umfasst:
- eine Antenne (2) zum Empfangen von Informationsträgersignalen,
- wenigstens einen Verstärker (3) mit geringem Rauschen, um die von der Antenne aufgefangenen Signale zu verstärken und zu filtern,
- einen Hilfsoszillator (6), um Hochfrequenz-Oszillationssignale (S_{I}, S_{Q}) zu liefern,
- wenigstens einen Mischerblock (4, 5), um die aufgefangenen, gefilterten und verstärkten Signale mit den Hochfrequenz-Oszillationssignalen, die von dem Hilfsoszillator geliefert werden, zu mischen, um Zwischensignale (I_{INT}, Q_{INT}) zu erzeugen, deren Frequenz gleich der Differenz zwischen der Frequenz der Hochfrequenz-Oszillationssignale und einer Trägerfrequenz der aufgefangenen Signale liegt,
- wenigstens ein Tiefpassfilter (8, 9), um die Zwischensignale zu filtern,
- eine Datenverarbeitungseinheit (15) nach einem der vorhergehenden Ansprüche und
- einen Demodulator (12), der die gefilterten Zwischensignale empfängt, um ein Datensignal (D_{OUT}) an die Datenverarbeitungseinheit (15) zu liefern.

13. Empfänger (1) nach Anspruch 12, **dadurch gekennzeichnet, dass** er ein Empfänger von Funkfrequenzsignalen mit FSK-Datenmodulation ist.

14. Empfänger (1) nach Anspruch 12, **dadurch gekennzeichnet, dass** das lokale Taktsignal (CLK) von einem Referenzsignal des Hilfsoszillators (6) stammt, dessen Frequenz durch eine Reihe von Teilern geteilt wird, dass die Frequenz des lokalen Taktsignals so beschaffen ist, dass sie 10 bis 100 mal größer als die Frequenz des Datendurchsatzes des Datensignals ist und vorzugsweise 45 mal der Frequenz des Datendurchsatzes ist.

## Claims

1. Data processing unit (15) for a receiver (1) of signals carrying data, said unit including:
- a clock and data recovery circuit (16), which is clocked by a local clock signal (CLK) and which includes a numerical phase lock loop, in which there is arranged a numerically controlled oscillator (25) to generate at output at least one pulse signal (I_{P}, Q_{P}), the phase and frequency of which can be adapted on the basis of a data signal (D_{OUT}) received at the input of the clock and data recovery circuit (16), and
- a processor circuit (17) connected to the clock and data recovery circuit (16),
**characterized in that** the processor circuit (17) is arranged to be able to calculate the mean and variance over time of the numerical input signal (NCO_{IN}) of the numerically controlled oscillator (25) so as to determine the coherence of the data signal (D_{OUT}) if the calculated mean and variance are below a predefined coherence threshold, and to be able to perform a complete reset of the receiver (1) if the calculated mean or variance of the numerical input signal (NCOᵢₙ) of the numerically controlled oscillator are above the predefined coherence threshold.

2. Data processing unit (15) according to claim 1, **characterized in that** the numerically controlled oscillator (25) is arranged to supply at output an in-phase pulse signal (I_{P}) and a quadrature pulse signals (Q_{P}).

3. Data processing unit (15) according to claim 2, **characterized in that** the numerical phase lock loop includes a first clock counter (21) to receive the data signal (D_{OUT}) at input and to be clocked by the local clock signal (CLK) to oversample the data signal (D_{OUT}), wherein the first counter (21) is arranged to be reset at a reset input (Q_{R}) at each pulse of the quadrature pulse signal (Q_{P}) supplied by the numerically controlled oscillator (25), and an output signal value (H_{OUT}) of the first counter (21) at the time of reset following a binary transition of the data signal (D_{OUT}) enables the numerically controlled oscillator (25) to be adapted.

4. Data processing unit (15) according to claim 2, **characterized in that** the in-phase pulse signal (I_{P}) supplied by the numerically controlled oscillator (25) defines a recovered data clock signal (R_{H}).

5. Data processing unit (15) according to claim 3, **characterized in that** the numerical phase lock loop includes a numerical loop filter (23) for filtering the output signal (H_{OUT}) of the first clock counter (21) so as to supply a numerical input signal (NCO_{IN}) to the numerically controlled oscillator (25) during a pulse of the quadrature pulse signal (Q_{P}) following a binary transition in the data signal (D_{OUT}).

6. Data processing unit (15) according to claim 5, **characterized in that** the loop filter (23) is arranged to attenuate by a factor K, such as a factor equal to 0.25, the output signal of the first counter (21) to supply the numerical input signal (NCO_{IN}).

7. Data processing unit (15) according to any of the claims 3, 5 OR 6, **characterized in that** the clock and data recovery circuit (16) includes a second data bit counter (24) to receive the data signal (D_{OUT}) at input and to be clocked by the local clock signal (CLK) to oversample the data signal (D_{OUT}), and **in that** the second data bit counter (24) is arranged to be reset at a reset input (I_{R}) on each pulse of the in-phase pulse signal (I_{P}) supplied by the numerically controlled oscillator (25).

8. Data processing unit (15) according to claim 7, **characterized in that** the clock and data recovery circuit (16) includes a transition detector (26) to receive the output signal (B_{OUT}) of the second data bit counter (24) so as to supply a recovered data signal (R_{H}) at output.

9. Data processing unit (15) according to claim 7, **characterized in that** the numerical phase lock loop includes a multiplier (22) for multiplying the output signal (H_{OUT}) of the first clock counter (21) by the output signal (B_{OUT}) of the second data bit counter (24), which is arranged to take a value of "+1" for a data signal bit that is "1" and a value of "-1" for a data signal bit that is "0", so as to supply to the loop filter (23) an output signal (H_{OUT}) of the first clock counter (21) whose polarity is adapted to the current data signal bit (D_{OUT}).

10. Data processing unit (15) according to claim 8, **characterized in that** the transition detector (26) is clocked by the in-phase pulse signal (I_{P}) of the numerically controlled oscillator (25), and **in that** the transition detector supplies a control signal to the loop filter (23) forcing said loop filter to maintain the preceding numerical input signal (NCO_{IN}) to be supplied to the numerically controlled oscillator if the transition detector (26) does not detect any binary transition of the data signal (D_{OUT}) from one bit to the other.

11. Data processing unit (15) according to claim 1, **characterized in that** the processor circuit (17) includes storage means in which a moving average algorithm and/or a moving max-min algorithm are stored, in order to calculate the mean and variance over time of the numerical input signal (NCO_{IN}) of the numerically controlled oscillator (25), so as to determine the coherence of the data signal (D_{OUT}).

12. Receiver (1) of signals carrying data, said receiver including:
- an antenna (2) for receiving signals carrying data,
- at least one low noise amplifier (3) for amplifying and filtering the signals picked up by the antenna,
- a local oscillator (6) for supplying high frequency oscillating signals (S_{I}, S_{Q}),
- at least one mixer unit (4, 5) for mixing the received filtered and amplified signals with the high frequency oscillating signals supplied by the local oscillator in order to produce intermediate signals (I_{INT}, Q_{INT}), whose frequency is equal to the difference between the frequency of the high frequency oscillating signals and a carrier frequency of the received signals,
- at least one low pass filter (8, 9) for filtering the intermediate signals,
- a data processing unit (15) according to any of the preceding claims, and
- a demodulator (12) receiving the filtered intermediate signals to supply a data signal (D_{OUT}) to the data processing unit (15).

13. Receiver (1) according to claim 12, **characterized in that** it is an FSK type RF receiver.

14. Receiver (1) according to claim 12, **characterized in that** the local clock signal (CLK) originates from a reference signal of the local oscillator (6), whose frequency is divided by a series of dividers, and **in that** the local clock signal frequency is arranged to be between 10 and 100 times higher than the data flow frequency of the data signal, and preferably equal to 45 times the data flow frequency.
